Europäisches Patentamt

European Patent Office

Office européen des brevets

(11) Publication number: **0 207 221**
**A1**

## (12) EUROPEAN PATENT APPLICATION

(21) Application number: 86103227.4

(22) Date of filing: **11.03.86**

(51) Int. Cl.4: **F02P 19/02** , **H01H 9/54**

(30) Priority: **11.04.85 US 722239**

(43) Date of publication of application:
**07.01.87 Bulletin 87/02**

(84) Designated Contracting States:
**DE FR GB IT SE**

(71) Applicant: **ALLIED CORPORATION**
**Columbia Road and Park Avenue P.O. Box**
**2245R (Law Dept.)**
**Morristown New Jersey 07960(US)**

(72) Inventor: **Roberts, William James**
**c/o Allied Corporation P.O. Box 5060**
**Southfield, MI 48086(US)**

(74) Representative: **Brullé, Jean et al**
**Service Brevets Bendix 44, rue François 1er**
**F-75008 Paris(FR)**

(54) **Bias control circuit.**

(57) A bias circuit controlling the power transistor - (Q2) in a transistor amplifier circuit for suspressing the arc formed across the bimetal contacts in a glow plug (18) controller for diesel engines. The bias circuit generates a load line for a transistor (Q2) which has a high voltage, low current portion and a high current, low voltage portion. The arc is formed when the bimetal contacts, which may be slow operating, is required to break a high current, high voltage line.

Fig.2

EP 0 207 221 A1

# BIAS CONTROL CIRCUIT

This invention relates to bias circuits in general and more particularly to bias control circuits for transistorized amplifiers having both a high current, low voltage and a high voltage, low current load lines.

## BACKGROUND OF THE INVENTION

In diesel engine motor vehicles, a glow plug is often used to ignite the fuel on those occasions when the fuel temperature is not high enough to allow combustion. Many of the glow plugs are controlled by electrothermally actuated switches or bimetal contacts which are opened and closed in response to the flow of current through the switch thereby heating the switch to a temperature. Such temperature is proportional to the temperature of the fuel and the probability of combustion.

A typical glow plug controller may have three heater operated bimetal contacts used in series to control a relay coil having heavy duty contactors. The contactors are connected in series between the glow plugs and the source of electrical power.

The bimetal contacts, by controlling the relay coil, are required to make and break electrical current paths. As such, considerable electrical arcing may occur across the contacts resulting in contact failure. In a typical controller, there are three such bimetal contacts in series. The first contact is a circuit breaker contact and generally does not operate except in response to heavy current overloads. The second contact is a thermal oscillator and operates to modulate the temperature of the glow plugs. The thermal oscillator contacts energizes and deenergizes a relay coil and as such makes and breaks a relatively heavy current load. The third contact, the afterglow contact, controls the time that the glow plug controller operates. It is normally closed and is opened from electrical current supplied to its heater from the alternator after the engine is started and running. If all timing is off, these contacts may have to open the relay current line, but generally the thermal oscillator contacts are open.

The opening of the bimetal contacts when current is being supplied to the relay results in arc across the contact and eventual destruction of the contact. When the contacts are destroyed, the vehicle may not start and there are times when such non starting may result in a dangerous situation.

## SUMMARY OF INVENTION

It is a principle advantage of the invention to reduce the arc drawn across the bimetal contacts, thereby making the operation of the bimetal contacts more reliable. It is further advantage of the present invention to provide an arc supresssion circuit to protect the bimetal contacts.

These and other advantages are found in the bias control circuit for a transistor amplifier circuit of the present invention. The transistor amplifier circuit has at least one electrothermally actuated contact and a load means electrically connected in series. The bias control circuit has a first bias circuit operable for generating a first load line for the transistor means in the transistor amplifier circuit. The first bias circuit provides a base voltage level to the transistor means to allow a high current, low voltage condition across the electrothermally actuated contact. A second bias circuit operable for generating a second load line for the transistor means. The second bias circuit is electrically connected in parallel with the first bias circuit, and provides a base voltage level to the transistor means for allowing a high voltage, low current condition across the electrothermally actuated contact.

## DESCRIPTION OF THE DRAWINGS

These and other advantages will become apparent from the following drawings and detailed description in which:

FIGURE 1 is a schematic of the portion of the glow plug controller in which the arc occured.

FIGURE 2 is a schematic of the bias circuit of the present invention.

FIGURE 3 is a graph of the load line of the transistor amplifier.

## DETAILED DESCRIPTION

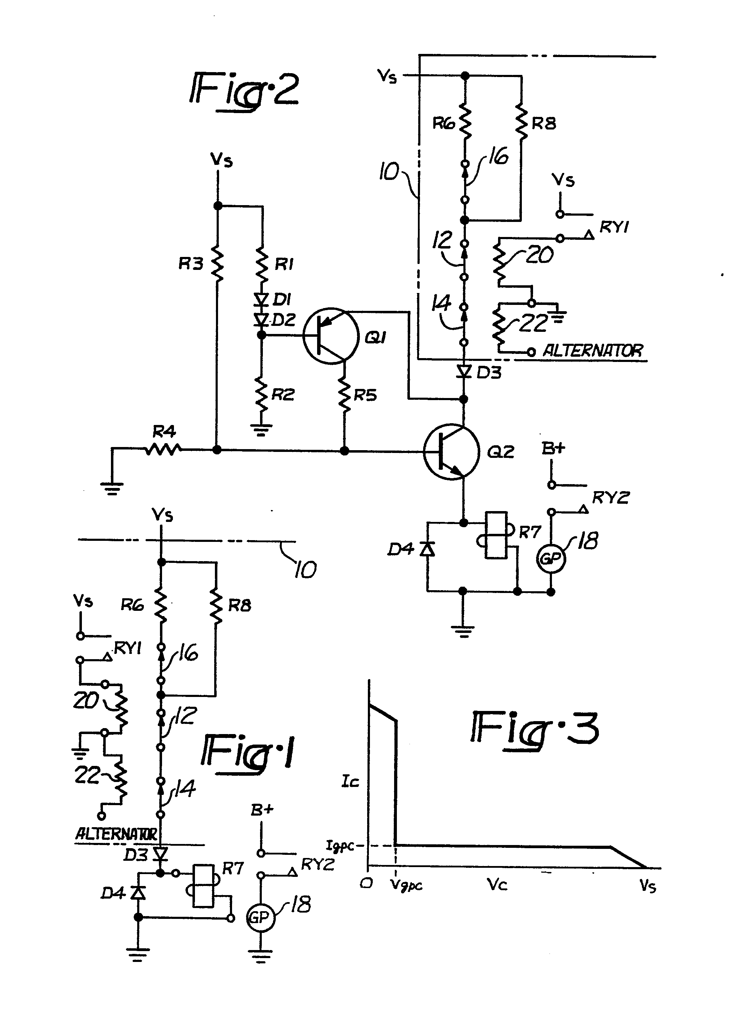

FIGURE 1 illustrates in schematic form, the prior art glow plug controller with the series circuit of the bimetal contacts controlling a relay coil. It is to be appreciated that the complete glow plug controller is more extensive than that shown.

The series circuit comprises a heating resistor R6 connected to a circuit breaker contact. Electrically connected in parallel with the heating resistor R6 and the circuit breaker contact is another resistive element R8 which provides sufficient heat to keep the circuit breaker contact latched open once it is tripped.

The next two contacts illustrated in FIGURE 1 are the main bimetal contacts in the glow plug controller. One of the contacts functions as a thermal oscillator and operates to control the upper temperature limit of the glow plugs by modulating the power to the relay coil causing the relay contacts to open and close. The other of the contacts, called the afterglow contact, remains closed until its heater generates sufficient heat to open the contact. The heater is supplied by current from the vehicle alternator (not shown) and after a predetermined period of time the heater will generate a sufficient amount of heat to open the contacts and will remain open as long as the alternator is running.

The series circuit is completed by a load means or the coil of a relay having heavy duty contacts which connect the glow plug directly to the source of power. A rectifier is electrically connected in parallel with the coil of the relay to control inverse voltage spikes when the coil is deenergized.

In the operation of FIGURE 1, the power is supplied from the battery to the series circuit. The battery power is controlled by some means such as an ignition switch being turned to the start position. All contacts are normally closed and the relay coil is energized. The relay contacts, not shown, connect the glow plugs to the battery power and the plugs will become energized. The thermal oscillator contacts, being electrothermally operated contacts or bimetal switches, begin to heat and slowly open. Once opened the relay contacts open and the glow plugs cool.

Opening the thermal oscillator contacts interrupts the flow of current to the heater of the circuit breaker and the heater to the thermal oscillator contacts. Once the heater to the thermal oscillator contacts cools, the circuit is reclosed and the relay coil reenergized.

It has been found that the slow opening of the bimetal contacts causes an arc to be formed across the contacts. This arc causes the contacts to eventually fail and the control of the glow plugs is adversely affected. It is the elimination of this arc that is the goal of the bias control circuit or arc suppression circuit of the present invention.

Referring to FIGURE 2, the arc suppression circuit of the present invention is illustrated. The series circuit having the circuit breaker contact and its heater resistor R6 connected in series with the two bimetal contacts forming the thermal oscillator and the afterglow control and the relay coil now includes a power amplifier or transistor means Q2. The transistor means Q2 is a Darlington transistor that is controlled by a bias circuit comprising a first circuit control for low voltage high current through the contacts and a second circuit for high voltage, low current through the contacts. In addition, the second circuit functions to permit the use of low voltage relay control inasmuch as the Darlington transistor Q2 will absorb the power drop necessary to use the low voltage relay.

Electrically connected between the collector lead of the Darlington transistor Q2 and the bimetal contacts is an optional rectifier positioned to protect the circuit if the polarities of the voltage supply are reversed.

The first circuit has voltage divider circuit comprising resistors R1 and R2 connected across the power supply. At the junction of the resistros R1 and R2, the base lead of a control transistor Q1 is connected. The emitter lead of the control transistor Q1 is connected to the collector lead of the Darlington transistor Q2 and the collector lead of the control transistor Q1 is connected through a resistor R5 to the base lead of the Darlington transistor Q2. The resistor R5 is also connected to the return of the power supply or ground through a resistor R4.

The second circuit comprises a voltage divider circuit comprising two resistors R3 and R4 connected across the power supply. At the junction of the two resistors R3 and R4, the base lead of the Darlington transistor Q2 is connected. The voltage divider circuit functions to develop a low voltage for the base lead of the Darlington transistor Q2. In the preferred embodiment as illustrated, the power supply is a nominal 24 volt supply and the two resistors R3 and R4 are 3300 ohms and 680 ohms respectively, generating a voltage level of 4 volts to the base of the Darlington transistor Q2. When the second circuit controls the base voltage to the Darlington transistor Q2, the voltage drop across the bimetal contacts is high, but the current is low due to the electrical position of the relay coil in the emitter circuit of the Darlington transistor Q2.

In the first circuit, the voltage divider circuit resistors R1 and R2 are 470 ohms and 5600 ohms respectively, generating a voltage level of 22 volts at the base of the control transistor Q1. This voltage level coupled with the voltage on its collector being nearly equal to the supply voltage, will hold the collector of the Darlington transistor Q2 to a voltage equal to the base voltage plus the voltage across the emitter to base junction. When the first circuit controls the base voltage to the Darlington transistor, the voltage drop across the bimetal contacts is low but the current flowing through the contacts is high. When the control transistor Q1 is conducting, the base voltage on the Darlington transistor Q2 is a function of the voltage on the collector lead, the resistors R3, R4, and R5 and the supply voltage. In the nominal case, this voltage is thirteen volts leaving the voltage drop across the Darlington transistor of approximately nine volts.

Upon ignition turn on, power is supplied to the series circuit and to the bias circuit. The control transistor Q1 biases the Darlington transistor Q2 to have a collector voltage slightly below the supplied power and a base voltage sufficient to have the emitter voltage sufficient to energize the relay coil. As current flow through the series circuit, the relay coil energizes causing its contacts to close for heating the glow plugs. The current through the thermal oscillator bimetal contacts begins to heat the bimetal. Once the bimetal is heated, the thermal oscillator contacts open, removing power from the relay and the series circuit. This heating and cooling will continue until the afterglow contacts open. This will happen a period of time after the alternator on the engine is operated. As previously stated, the current generated by the alternator is supplied to the afterglow contact heater.

The second circuit operates to maintain a current flow through the series circuit when the circuit breaker has opened and the flow of current is limited by the circuit breaker heater resistor R8. The base voltage on the Darlington transistor is only a few volts, hence the collector current is very low.

In summary there has been shown and described an arc suppression circuit as may be used to control the flow of current through a series circuit containing one or more bimetal contacts. The arc suppression circuit or bias circuit, operates to a low power condition across the bimetal contacts in order to reduce or prevent the formation of an electrical arc which operates to destroy the contacts. When the current is high, the voltage drop across the bimetal contacts is low and when the current through the bimetal contacts is low, the voltage drop across the contacts is high, but in both cases the amount of power is small, hence the arc is either non-destructive or non-existent.

**Claims**

1. A bias control circuit for a transistor means - (Q2) in an amplifier circuit having at least one contact means (12) and a load means (R7) electrically connected in series, the bias control circuit comprising:

a first bias circuit operable for generating a first load line for the contact means (12), having a control transistor (Q1) with its emitter-collector circuit electrically connected between the base and one of said collector or emitter leads of the transistor means (Q2) and its base circuit providing a base voltage level for the transistor means (Q2) for allowing a high current, low voltage condition across the contact means (12); and

a second bias circuit operable for generating a second load line for the contact means (12) and electrically connected in parallel with said first bias circuit and operable for providing a base voltage level to the transistor means (Q2) for allowing a high voltage, low current condition across the contact means (12).

2. A bias control circuit for a transistor means - (Q2) in an amplifier circuit having at least one contact means (12) and a load means (R7) electrically connected in series, the bias control circuit comprising:

a first bias circuit operable for generating a first load line for the contact means (12), said first bias circuit providing a base voltage level to the transistor means (Q2) for allowing a high current, low voltage condition across the contact means (12); and

a second bias circuit operable for generating a second load line for the contact means (12) and electrically connected in parallel with said first bias circuit, said second circuit providing a base voltage level to the transistor means (Q2) for allowing a high voltage, low current condition across the contact means (12).

3. A bias control circuit for a transistor means in an amplifier circuit according to Claim 2 wherein said first bias circuit comprises a control transistor (Q1) having its emitter-collector circuit electrically connected between the base and one of the emitter collector leads of the transistor means (Q2), its base circuit electrically connected to a voltage source adapted to maintain a low voltage across the contact means (12).

4. A bias control circuit for a transistor means in an amplifier circuit according to Claim 2 wherein said second bias circuit comprises a voltage source electrically connected to the base circuit of the transistor means (Q2) and adapted to maintain a low current through the contact means (12).

5. An arc suppression circuit for bimetal control devices comprising:

a load means (R7) electrically conntected in series with the bimetal control devices (12,14);

a transistor means (Q2) having its collector-emitter circuit electrically connected in series between said load means (R7) and the bimetal control devices - (12,14); and

a bias circuit means electrically connected to the base circuit of said transistor means (Q2) and operable for controlling said transistor means maintaining a low voltage, high current condition across the bimetal control devices (12,14).

6. An arc suppression circuit for bimetal control devices according to Claim 5 additionally including a second bias circuit means electrically connected to the base circuit of said transistor means (Q2) and in parallel with said bias circuit, said second bias circuit operable for controlling said transistor means (Q2) maintaing a high voltage, low current condition across the bimetal control devices - (12,14).

7. An arc suppression circuit for bimetal control devices according to Claim 5 wherein said load means (R7) is a coil for a relay having at least one contact (RY2) control the connection of power to at least one glow plug (18).

8. An arc suppression circuit for bimetal control devices according to Claim 5 wherein said transistor means (Q2) is a Darlington transistor.

9. An arc suppression circuit for bimetal control devices according to Claim 5 wherein said bias circuit includes a control transistor (Q1) having its emitter collector circuit electrically connected across the base and one of the emitter and collector leads of said transistor means (Q2) and the base of said control transistor (Q1) biased to cause a low voltage drop between the transistor means (Q2) and the bimetal control devices (12,14).

10. An arc suppression circuit for bimetal control devices according to Claim 9 wherein said second bias circuit comprises a voltage source electrically connected to the base circuit of said transistor means (Q2) and adapted to maintain a low current through the bimetal control devices - (12,14).

0 207 221

Fig·2

Fig·1

Fig·3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | US-A-4 337 389 (L.E. BELL)<br>* figure 1; abstract *<br><br>--- | 1 | F 02 P  19/02<br>H 01 H   9/54 |
| A | DE-A-3 120 529 (NIPPONDENSO)<br>* figure 3, abstract *<br><br>--- | 3,8 | |
| A | GB-A-2 069 243 (LONDON TRANSPORT EXECUTIVE)<br>* figure 1; page 1, lines 9-14 *<br><br>--- | | |
| A | US-A-4 250 531 (W.C. AHRENS)<br><br>* figure 1, abstract *<br><br>----- | | |

TECHNICAL FIELDS
SEARCHED (Int. Cl.4)

F 02 P  19/02
H 01 H   9/54

The present search report has been drawn up for all claims

| Place of search | Date of completion of the search | Examiner |
|---|---|---|
| BERLIN | 02-09-1986 | BREUSING J |